# EUROPÄISCHE PATENTANMELDUNG

(11) **EP 2 442 376 A1**
(43) Veröffentlichungstag der Anmeldung: **18.04.2012**
(21) Anmeldenummer: 10306084.4
(22) Anmeldetag: 05.10.2010
(51) Int. Cl.: H01L 39/24, H01B 12/02

(54) **Verfahren zur Herstellung eines supraleitfähigen elektrischen Leiters und supraleitfähiger Leiter**

(71) Anmelder: Nexans, 75008 Paris (FR)
(72) Erfinder: Soika, Rainer, 30559 Hannover (DE); West, Beate, 30163 Hannover (DE)
(74) Vertreter: Döring, Roger

(57) **Zusammenfassung**

Es wird ein Verfahren zur Herstellung eines supraleitfähigen elektrischen Leiters angegeben, der als supraleitfähiges Material ein keramisches Material aufweist. Zur Durchführung des Verfahrens wird um eine Vielzahl von flachen Streifen (1) eines mit dem supraleitfähigen, keramischen Material beschichteten Trägers ein Metallband (3) längseinlaufend zu einem Rohr mit einem in Längsrichtung verlaufenden Schlitz herumgeformt, dessen am Schlitz aneinander liegende Kanten miteinander verschweißt werden. Die Streifen (1) werden dem Rohr mit ständigem Platztausch derart zugeführt, daß jeder Streifen im Verlauf des Leiters unterschiedliche Positionen im Querschnitt desselben einnimmt. Das durch den Schweißvorgang geschlossene Rohr (9) wird anschließend auf eine lichte Weite reduziert, die etwa einer Umhüllenden aller im Rohr befindlichen Streifen (1) entspricht.

## Beschreibung

Die Erfindung bezieht sich auf ein Verfahren zur Herstellung eines supraleitfähigen elektrischen Leiters, der als supraleitfähiges Material ein keramisches Material aufweist sowie auf einen supraleitfähigen Leiter (EP 1 916 720 B1).

Ein mit dem Verfahren nach der Erfindung herzustellender supraleitfähiger elektrischer Leiter besteht aus einem Verbundwerkstoff, dessen supraleitfähiges keramisches Material bei ausreichend tiefen Temperaturen in den supraleitfähigen Zustand übergeht. Der elektrische Gleichstromwiderstand eines aus einem solchen Material aufgebauten Leiters ist bei ausreichender Kühlung Null, solange eine bestimmte Stromstärke nicht überschritten wird. Geeignete keramische Materialien sind beispielsweise BSCCO (Wismut-Strontium-Kolzium-Kupfer-Oxid) oder ReBCO (Rare-earth-Barium-Kupfer-Oxid), insbesondere YBCO (Yttrium-Barium-Kupfer-Oxid). Ausreichend niedrige Temperaturen, um ein derartiges Material in den supraleitfähigen Zustand zu bringen, liegen beispielsweise zwischen 67 K und 110 K. Geeignete Kühlmittel sind beispielsweise Stickstoff, Helium, Neon und Wasserstoff oder Gemische dieser Stoffe.

Die US-A-5 739 086 beschreibt unterschiedliche Verfahren zur Herstellung von bandförmigen, als Hochtemperatur-Supraleiter bezeichneten elektrischen Leitern. Bei einem BSCCO-Supraleiter wird das BSCCO-Material beispielsweise in Pulverform in ein Rohr aus Silber eingefüllt und verdichtet. Durch mechanische Verformung des Rohres und anschließende Wärmebehandlung (Glühen) wird der supraleitfähige Zustand erreicht. Beim YBCO-Supraleiter wird auf ein beispielsweise biaxial texturiertes Band aus Metall als Substrat zunächst mindestens eine Pufferschicht aufgebracht, auf welche anschließend das YBCO-Material aufgetragen wird. Das biaxial texturierte

Substrat besteht beispielsweise aus Nickel, Kupfer oder Eisen oder einer Legierung dieser Materialien. Für die Pufferschicht werden beispielsweise Kupfer oder Silber eingesetzt. Das YBCO-Material wird abschließend ebenfalls durch Wärmebehandlung in den supraleitfähigen Zustand gebracht. Der so hergestellte supraleitfähige Leiter kann - wie schon erwähnt - mit Vorteil in elektrischen Kabeln sowie Wicklungen für elektrische Motoren und Magnete eingesetzt werden. Er kann dabei aber wegen seiner Bandform nur in einer Richtung gebogen werden.

Mit dem Verfahren nach der eingangs erwähnten EP 1 916 720 B 1 wird ein runder supraleitfähiger Leiter hergestellt, der wie ein herkömmlicher Draht verarbeitet werden kann, ohne daß beim Biegen eine besondere Richtung eingehalten werden muß. Mit diesem bekannten Verfahren wird ein als Band vorliegendes, texturiertes metallisches Substrat zunächst in seiner Längsrichtung um einen langgestreckten, metallischen Träger mit kreisförmigem Querschnitt herum zu einem Schlitzrohr mit sich in Längsrichtung erstreckenden, an einem Schlitz aneinander liegenden Kanten geformt. Das Schlitzrohr wird anschließend durch Verschweißen des Schlitzes geschlossen. Das geschlossene Rohr wird danach bis zur Anlage am Träger heruntergezogen. Das supraleitfähige keramische Material wird daraufhin rundum auf das Rohr aufgebracht und abschließend wird eine Wärmebehandlung durchgeführt. Dieses Verfahren hat sich in der Praxis bewährt. Für seine Durchführung ist jedoch ein relativ hoher Aufwand erforderlich.

Der Erfindung liegt die Aufgabe zugrunde, ein einfach durchführbares Verfahren zur Herstellung eines supraleitfähigen elektrischen Leiters anzugeben, der sowohl für Gleichstrom - als auch für Wechselstromübertragung eine gleichmäßige Stromverteilung im gesamten Querschnitt aufweist.

Diese Aufgabe wird gemäß der Erfindung dadurch gelöst,
- daß um eine Vielzahl von flachen Streifen eines mit dem supraleitfähigen keramischen Material beschichteten Trägers ein Metallband längseinlaufend zu einem Rohr mit einem in Längsrichtung verlaufenden Schlitz herumgeformt wird, dessen am Schlitz aneinander liegende Kanten miteinander verschweißt werden,
- daß die Streifen dem Rohr mit ständigem Platztausch derart zugeführt werden, daß jeder Streifen im Verlauf des Leiters unterschiedliche Positionen im Querschnitt desselben einnimmt, und
- daß das durch den Schweißvorgang geschlossene Rohr anschließend auf eine lichte Weite reduziert wird, die etwa einer Umhüllenden aller im Rohr befindlichen Streifen entspricht.

Bei Einsatz dieses Verfahrens braucht nur eine Anzahl von Streifen von einem vorgefertigten Band, das einen mit supraleitfähigem Material beschichteten Träger aufweist, abgetrennt und in das Rohr eingebracht zu werden. Das Rohr wird beispielsweise in aus der EP 1 916 720 B1 bekannter Technik aus einem längseinlaufenden Metallband geformt und zu einem geschlossenen Rohr verschweißt. Das geschlossene Rohr wird abschließend so weit in seinen lichten Abmessungen reduziert, bis es die Gesamtheit der Streifen möglichst eng umschließt, ohne daß Druck auf dieselben ausgeübt wird. Das supraleitfähige Material ist im fertigen Leiter innerhalb des Rohrs vor mechanischen Beschädigungen geschützt untergebracht. Der mit diesem Verfahren hergestellte Leiter kann daher ohne besondere Vorsichtsmaßnahmen eingesetzt und mit handelsüblichen Vorrichtungen verarbeitet werden. Durch den ständigen Platztausch der Streifen bei ihrem Zuführen in das Rohr kommt hinzu, daß der bei Wechselstrombetrieb bekannte Effekt der Stromverdrängung (Skineffekt) bezüglich der Stromverteilung im Leiterquerschnitt neutralisiert ist, weil durch den Einsatz dieses Verfahrens alle Streifen auch bei Wechselstrombetrieb vom Strom durchflossen werden. Dies führt dann zusammen mit der Vielzahl von in dem Rohr befindlichen Streifen mit supraleitfähigem Material dazu, daß der Leiter im Wechselstrombetrieb nur geringe Wechselstromverluste in einem entsprechenden Kabel erzeugt.

Mit Vorteil wird zusätzlich zu den Streifen ein Füllmaterial in das Rohr eingebracht, das zusammen mit den Streifen die lichten Abmessungen des Rohres ausfüllt. Ein solches Material ist vorzugsweise ein bei niedrigen Temperaturen schmelzendes Metall, das im flüssigen oder zähflüssigen Zustand in das noch offene Rohr eingefüllt wird. Es umgibt im fertigen Leiter die Streifen mit dem supraleitfähigen Material in verfestigtem Zustand, so daß eine elektrische Verbindung des Leiters mit anderen elektrischen Leitern mit üblichen Kontaktelementen möglich ist.

Das Verfahren nach der Erfindung und er damit hergestellte Leiter werden anhand der Zeichnungen in Ausführungsbeispielen erläutert.

Es zeigen:
Fig. 1 in schematischer Darstellung eine Vorrichtung zur Durchführung des Verfahrens nach der Erfindung.
Fig. 2 einen Schnitt durch Fig. 1 längs der Linie 11 - 11 in vergrößerter Darstellung.
Fig. 3 den Leiter nach der Erfindung in einem Schnitt durch Fig. 1 längs der Linie 111 - 111 ebenfalls in vergrößerter Darstellung.
Fig. 4 den Leiter mit einer gegenüber den Fig. 2 und 3 abgewandelten Querschnittsform.
Fig. 5 und 6 eine Einzelheit der Vorrichtung nach Fig. 1 in zwei unterschiedlichen Ausführungsformen.

Für den Leiter nach der Erfindung wird als supraleitfähiges Material allgemein ReBCO eingesetzt und insbesondere YBCO, das in der folgenden Beschreibung als spezielles ReBCO-Material berücksichtigt wird.

Die Herstellung von Bändern mit einem Träger, auf dem YBCO abgeschieden ist, geht beispielsweise aus der eingangs erwähnten US-A- 5 739 086 hervor. Derartige Bänder sind auf dem Markt erhältlich. Sie sind beispielsweise zwischen 4 cm und 10 cm breit.

Zur Durchführung des Verfahrens nach der Erfindung wird ein vorgefertigtes mit YBCO beschichtetes Band in Streifen geschnitten, die beispielsweise 0,2 mm bis 4 mm breit sind. Das im folgenden verwendete Wort "Streifen" ist ein derart schmaler flacher Streifen aus einem mit YBCO beschichteten Träger. Diese Streifen können zunächst von einem Band abgetrennt und auf eine Spule aufgewickelt werden. Sie können aber auch im Anschluß an den Trennvorgang direkt weiterverarbeitet werden.

Zur Herstellung des supraleitfähigen Leiters kann mit Vorteil zunächst um eine Vielzahl von flachen Streifen mit supraleitfähigem Material ein Metallband längs laufend zu einer Hülle herumgeformt und verschweißt werden, ohne bereits dabei den ständigen Platztausch durchzuführen. Auf diese Weise wird ein eine Vielzahl von Streifen enthaltender Runddraht erzeugt. Der ständige Platztausch der Streifen im Querschnitt des Leiters wird dadurch erreicht, daß mehrere von derartigen vorgefertigten Runddrähten mit einer vorgebbaren Schlaglänge miteinander verseilt werden, und zwar ohne Rückdrehung. Dabei kann zusätzlich ein zentrales Kernelement vorgesehen werden, um das die Runddrähte herumverseilt werden.

Aufgrund der nicht durchgeführten Rückdrehung der Runddrähte als Verseilelemente wird ein Platztausch der Streifen im Querschnitt der resultierenden Anordnung, dem Leiter, erreicht. Das führt dazu, daß alle Streifen einen über die Länge des Leiters gemittelten gleichen Durchschnittsabstand vom Zentrum desselben haben. Dadurch ist eine Gleichverteilung des Wechselstroms in den Streifen bzw. im Leiter erreicht.

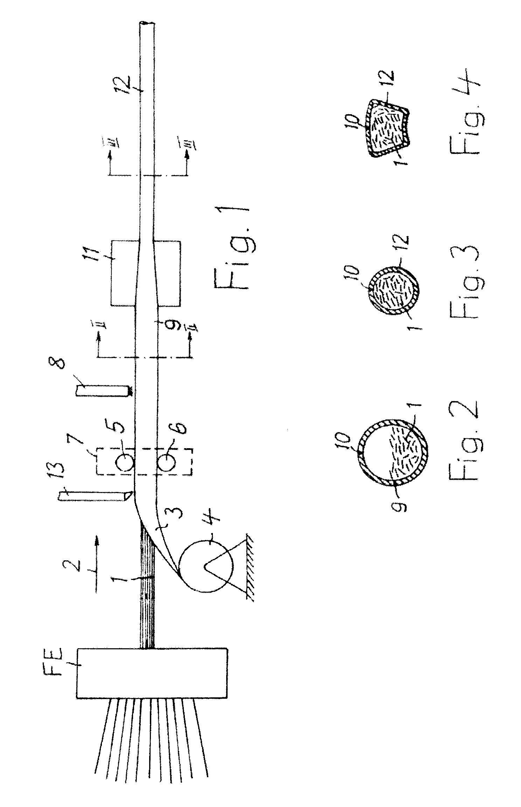

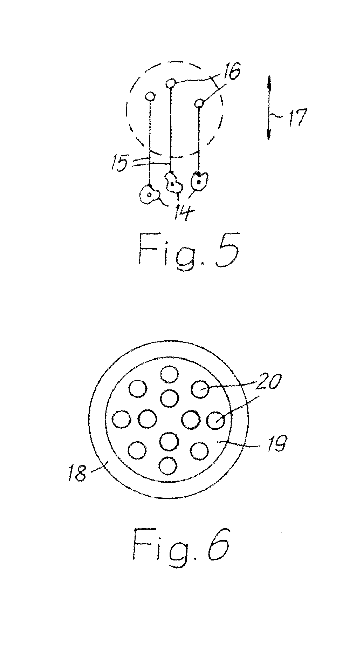

Das Verfahren nach der Erfindung kann entsprechend den Fig. 5 und 6, die rein schematisch mögliche Vorrichtungen zum Zuführen der Streifen mit supraleitfähigem Material wiedergegeben, beispielsweise wie folgt durchgeführt:
Eine größere Anzahl von Streifen 1 wird mittels einer nicht mit dargestellten Abzugseinrichtung in Richtung des Pfeiles 2 bewegt. Dabei treten die Streifen 1 durch eine Führungseinrichtung FE hindurch, deren mögliche Arbeitsweise weiter unten anhand der Fig. 5 und 6 erläutert wird. In der Führungseinrichtung FE werden die Streifen 1 ständig einem Platztausch unterworfen. Um die Streifen 1 wird nach dem Verlassen der Führungseinrichtung FE ein Metallband 3, das mittels der gleichen Abzugseinrichtung wie die Streifen 1 von einer Spule 4 abgezogen werden kann, in einer durch zwei Rollen 5 und 6 angedeuteten Formungseinheit 7 längseinlaufend zu einem Rohr mit einem in Längsrichtung verlaufenden Schlitz geformt, an dem die Kanten des Metallbandes 3 aneinander liegen. Der Schlitz wird danach in einer Schweißeinrichtung 8 verschweißt. Das damit geschlossene Rohr 9 geht aus Fig. 2 hervor. Die Streifen 1 liegen im unteren Bereich des Rohres 9, das im oberen Bereich durch eine Schweißnaht 10 verschlossen ist.

Das Metallband 3 kann beispielsweise aus Kupfer, Aluminium oder Edelstahl, aber auch aus einer Legierung dieser Materialien, wie beispielsweise Bronze, bestehen.

In einer in Abzugsrichtung (Pfeil 2) folgenden Zieheinheit 11 wird das Rohr 9 auf eine lichte Weite reduziert, die etwa einer Umhüllenden aller im Rohr 9 befindlichen Streifen 1 entspricht, so daß es die Streifen 1 nahezu berührt, ohne Druck auf dieselben auszuüben. Der damit fertiggestellte supraleitfähige Leiter 12 geht beispielsweise aus Fig. 3 hervor.

In das noch offene Rohr kann mittels einer Zuführeinheit 13 zusätzlich Füllmaterial in dasselbe eingefüllt werden. Als Füllmaterial wird vorzugsweise ein niedrigschmelzendes Metall verwendet, das im flüssigen bzw. zähflüssigen Zustand in das Rohr eingefüllt wird und bei Raumtemperatur sowie insbesondere bei den niedrigen, zur Erzeugung der Supraleitfähigkeit angewendeten Temperaturen fest ist. Ein solches Metall ist beispielsweise Woodsches Metall, das bei etwa 73 °C bis 77 °C schmilzt, oder Roses-Metall mit einem bei etwa 95 °C liegenden Schmelzpunkt.

Der Leiter 9 bzw. 12 ist gemäß den Fig. 2 und 3 kreisrund ausgeführt. Er kann aber auch einen von der Kreisform abweichenden Querschnitt haben, mit einer beispielsweise polygonalen Querschnittsform. Die jeweilige Querschnittsform kann mit Vorteil in der Zieheinheit 11 erzeugt werden. In einer bevorzugten, in Fig. 4 dargestellten Ausführungsform hat der Leiter 12 einen etwa trapezförmigen Querschnitt mit zwei einander gegenüberliegenden gebogenen Seitenflächen. Ein solcher Leiter eignet sich besonders als Einzelelement zum Aufbau eines Leiterseils aus einer Vielzahl solcher Leiter.

Die Führungseinheit FE kann unterschiedlich aufgebaut sein. Sie soll nach Möglichkeit mit herkömmlichen, aus der Kabeltechnik bekannten Elementen arbeiten. Zwei mögliche Ausführungsformen der Führungseinheit FE gehen aus den Fig. 5 und 6 hervor.

Die Führungseinheit FE nach Fig. 5 hat eine Vielzahl von nur schematisch angedeuteten Kurvenscheiben 14, die bei Durchführung des Verfahrens um ihre Achse gedreht werden. An den Umfangsflächen der Kurvenscheiben 14 liegen Stangen 15 mit einem Ende an, die an ihrem anderen Ende jeweils mit Ösen 16 ausgerüstet sind, durch welche bei Durchführung des Verfahrens jeweils mindestens ein Streifen 1 hindurchgeführt ist. Durch die Drehung der Kurvenscheiben 14 werden die Ösen 16 in Richtung des Doppelpfeils 17 hin- und herbewegt. Sie nehmen dadurch ständig einen anderen Platz im Querschnitt des Rohres 9 ein, das in Fig. 5 durch einen gestrichelt eingezeichneten Kreis 18 angedeutet ist.

Die Kurvenscheiben 14 können kontinuierlich mit gleichförmiger Geschwindigkeit um ihre Achse gedreht werden, so daß sich eine gezielte, systematische Verteilung der Streifen 1 im Querschnitt des Leiters ergibt. Sie können aber auch mit wechselnder Geschwindigkeit angetrieben werden. Das führt zu einer mehr zufälligen Verteilung der Streifen 1 im Querschnitt des Leiters.

Die Streifen 1 können bei einer anderen Ausführungsform des Verfahrens zunächst in einer Vorfertigung in mehreren Bündeln zusammengefaßt werden, die jeweils auf eine Spule aufgewickelt werden. Die Spulen können in Verseilrahmen von in der Kabeltechnik üblichen Verseilmaschinen oder in feststehenden Ablaufgestellen angeordnet werden.

Die Führungseinheit FE besteht bei dieser Ausführungsform gemäß Fig. 6 beispielsweise aus einer in einem Rahmen 18 gelagerten Scheibe 19, die um ihre Achse drehbar ist. Die Scheibe 19 hat mehrere Durchgangslöcher 20 zum Durchführen der vorgefertigten Bündel von Streifen. Sie kann gemeinsam mit dem die Bündel tragenden Verseilrahmen in gleichbleibender Richtung um ihre Achse gedreht werden. Sie kann aber auch mit reversierender Drehrichtung gedreht werden. Das bietet den Vorteil, daß für die Spulen der Bündel feststehende Abläufe eingesetzt werden können.

## Patentansprüche

1. Verfahren zur Herstellung eines supraleitfähigen elektrischen Leiters, der als supraleitfähiges Material ein keramisches Material aufweist, **dadurch gekennzeichnet,**
- **daß** um eine Vielzahl von flachen Streifen (1) eines mit dem supraleitfähigen, keramischen Material beschichteten Trägers ein Metallband (3) längseinlaufend zu einem Rohr mit einem in Längsrichtung verlaufenden Schlitz herumgeformt wird, dessen am Schlitz aneinander liegende Kanten miteinander verschweißt werden,
- **daß** die Streifen (1) dem Rohr mit ständigem Platztausch derart zugeführt werden, daß jeder Streifen im Verlauf des Leiters unterschiedliche Positionen im Querschnitt desselben einnimmt, und
- **daß** das durch den Schweißvorgang geschlossene Rohr (9) anschließend auf eine lichte Weite reduziert wird, die etwa einer Umhüllenden aller im Rohr befindlichen Streifen (1) entspricht.

2. Verfahren nach Anspruch 1, **dadurch gekennzeichnet, daß** der Platztausch der Streifen systematisch gezielt durchgeführt wird.

3. Verfahren nach Anspruch 1, **dadurch gekennzeichnet, daß** der Platztausch der Streifen mit zufälliger Verteilung durchgeführt wird.

4. Verfahren nach Anspruch 1, **dadurch gekennzeichnet, daß** die Streifen zunächst in mehreren, von einander getrennten Bündeln zusammengefaßt werden, die während ihrer Zuführung zum Rohr relativ zueinander und bezogen auf den Rohrquerschnitt in Umfangsrichtung bewegt werden.

5. Verfahren nach Anspruch 1, **dadurch gekennzeichnet,**
- **daß** zunächst mehrere Runddrähte gefertigt werden, in denen mehrere Streifen in einer gemeinsamen Hülle zusammengefaßt sind, und
- **daß** die Runddrähte ohne Rückdrehung miteinander verseilt werden.

6. Verfahren nach Anspruch 5, **dadurch gekennzeichnet, daß** die Runddrähte um ein zentrales Kernelement herumverseilt werden.

7. Verfahren nach einem der Ansprüche 1 bis 6, **dadurch gekennzeichnet, daß** neben den Streifen (1) Füllmaterial in das Rohr eingefüllt wird.

8. Verfahren nach Anspruch 7, **dadurch gekennzeichnet, daß** als Füllmaterial ein niedrigschmelzendes Metall verwendet wird.

9. Mit dem Verfahren nach Anspruch 1 hergestellter supraleitfähiger, elektrischer Leiter, **dadurch gekennzeichnet,**
- **daß** eine Vielzahl von flachen Streifen (1) eines mit supraleitfähigem, keramischem Material beschichteten Trägers in einem aus Metall bestehenden Rohr (12) angeordnet ist, dessen lichter Querschnitt durch die Streifen (1) nahezu vollständig ausgefüllt ist, und
- **daß** die Streifen (1) im Verlauf des Leiters unterschiedliche Positionen im Querschnitt desselben einnehmen.

10. Leiter nach Anspruch 9, **dadurch gekennzeichnet, daß** er einen kreisrunden Querschnitt hat.

11. Leiter nach Anspruch 9, **dadurch gekennzeichnet, daß** er einen trapezförmigen Querschnitt hat, mit zwei einander gegenüberliegenden gebogenen Seitenflächen.
